(19) Europäisches Patentamt / European Patent Office / Office européen des brevets

(11) **EP 2 038 669 B1**

(12) **EUROPÄISCHE PATENTSCHRIFT**

(45) Veröffentlichungstag und Bekanntmachung des Hinweises auf die Patenterteilung:
**13.06.2018   Patentblatt 2018/24**

(21) Anmeldenummer: **07728669.8**

(22) Anmeldetag: **30.04.2007**

(51) Int Cl.:
**G01R 31/40** *(2014.01)*     **G01R 19/165** *(2006.01)*

(86) Internationale Anmeldenummer:
**PCT/EP2007/054215**

(87) Internationale Veröffentlichungsnummer:
**WO 2008/000539 (03.01.2008 Gazette 2008/01)**

(54) **VERFAHREN ZUR ERWEITERUNG DER DIAGNOSEFÄHIGKEIT VON STROMREGLERN**

METHOD FOR EXTENDING THE DIAGNOSTIC CAPABILITY OF CURRENT REGULATORS

PROCÉDÉ POUR ÉTENDRE LA CAPACITÉ DE DIAGNOSTIC DE RÉGULATEURS D'INTENSITÉ DE COURANT

(84) Benannte Vertragsstaaten:
**DE**

(30) Priorität: **27.06.2006   DE 102006029389**

(43) Veröffentlichungstag der Anmeldung:
**25.03.2009   Patentblatt 2009/13**

(73) Patentinhaber: **Robert Bosch GmbH**
**70442 Stuttgart (DE)**

(72) Erfinder:
• **MARCATO, Danilo**
  **75172 Pforzheim (DE)**
• **NEUMEISTER, Jochen**
  **70469 Stuttgart (DE)**
• **RAUB, Hans**
  **72760 Reutlingen (DE)**
• **LAMMERS, Christian**
  **70839 Gerlingen (DE)**
• **REINHARDT, Steffen**
  **75173 Pforzheim (DE)**

(56) Entgegenhaltungen:
DE-A1- 3 616 975     DE-A1- 3 842 921
DE-A1- 10 124 109    DE-A1- 19 851 732
DE-C1- 4 344 013

**Beschreibung**

<u>Stand der Technik</u>

Elektronische Schaltendstufen werden in der Regel mittels Diagnoseverfahren auf Fehler untersucht. So ist bekannt, elektronische Schaltendstufen auf Lastabfall, bei dem kein Laststrom auftritt, auf Unterlast, bei der ein zu geringer Laststrom auftritt, auf Überlast, bei der ein zu hoher Laststrom auftritt, sowie auf Kurzschluss nach Masse und Kurzschluss nach Versorgungsspannung zu untersuchen. Darüber hinaus erfolgt in der Regel eine Diagnose der elektronischen Schaltendstufe auf Vorliegen oder Nichtvorliegen einer Übertemperatur. Bei den dargestellten Diagnoseverfahren wird zwischen Highsideschaltern (HS) und Lowsideschaltern (LS) unterschieden.

Die Erkennung des Fehlers im Rahmen der oben aufgezählten Diagnoseverfahren erfolgt in der Regel unter den nachfolgend dargestellten Voraussetzungen:
In Bezug auf die Highside-Endstufe erfolgt eine Diagnose auf Lastabfall bei eingeschalteter oder ausgeschalteter Endstufe über Anlegen eines Prüfstromes oder Anlegen eines Prüfpotenzials. Die Diagnose auf Lastabfall erfolgt durch eine Messung am Shunt beziehungsweise über eine Spannungsmessung an der Last.

Eine Diagnose auf Unterlast der elektronischen Schaltendstufe erfolgt in der Regel bei eingeschalteter Endstufe durch eine Messung eines Spannungsabfalls am Shunt.

Eine Diagnose auf Überlast erfolgt in der Regel ebenfalls bei eingeschalteter Endstufe über eine Messung des Spannungsabfalls an einem Shunt und/oder die Messung eines Durchschaltwiderstandes der Endstufe.

Eine Diagnose der elektronischen Schaltendstufe auf Kurzschluss nach Masse (niederohmig oder hochohmig) erfolgt in der Regel bei eingeschalteter Endstufe durch einen Spannungsabfall am Shunt und/oder die Ermittlung eines Durchschaltwiderstandes der Endstufe. Die Diagnose hinsichtlich eines Kurzschlusses auf Versorgungsspannung ($U_{bat}$), sei sie niederohmig oder hochohmig, erfolgt in der Regel bei ausgeschalteter Endstufe durch Anlegen eines Prüfstroms beziehungsweise eines Prüfpotenzials durch eine Spannungsmessung an der Last, wohingegen im Rahmen der oben aufgezählten Diagnoseverfahren eine Übertemperaturmessung immer durchgeführt wird und in der Regel über eine Temperaturmessung über die Ermittlung der Diodenspannung erfolgt. Alternativ kann auch ein temperaturabhängiger Widerstand gemessen werden.

In Bezug auf die Lowside der elektronischen Schaltendstufe erfolgt deren Diagnose auf Lastabfall bei ein- oder ausgeschalteter Endstufe durch Anlegen eines Prüfstroms beziehungsweise eines Prüfpotenzials. Die eingesetzte Messmethode ist in der Regel eine Messung des Spannungsabfalls an einem Shunt und/oder die Messung eines Durchschaltwiderstands der Endstufe sowie eine Spannungsmessung der Last.

Eine Diagnose hinsichtlich an der elektronischen Schaltendstufe anliegender Unterlast erfolgt bei eingeschalteter Endstufe durch eine Messung des Spannungsabfalls an einem Shunt. Gleiches gilt für die Diagnose einer Überlast. Ein Kurzschluss nach Masse (niederohmig, hochohmig) erfolgt bei ausgeschalteter Endstufe durch Anlegen eines Prüfstroms beziehungsweise eines Prüfpotenzials in der Regel durch Spannungsmessung an der Last. Die Diagnose auf Kurzschluss nach Versorgungsspannung ($U_{bat}$), sei es niederohmig oder hochohmig, erfolgt bei eingeschalteter Endstufe durch eine Spannungsmessung am Shunt, wohingegen analog zur Übertemperaturmessung der Highside der Endstufe eine Übertemperaturmessung stets durchgeführt wird, wozu eine Temperaturmessung über die Ermittlung der Diodenspannung beziehungsweise ein temperaturabhängiger Widerstand eingesetzt werden kann.

Die obenstehend skizzierten Diagnoseverfahren haben bei getakteten Endstufen und induktiven Lasten den Nachteil, dass im ausgeschalteten Zustand der Endstufe bei Taktung die Spannungsmessung an der Last nur noch eingeschränkt funktioniert. Dies bedeutet, dass zum Beispiel hochohmige Nebenschlüsse parallel zur Endstufe nicht mehr erkannt werden können, da die induktive Last das Potenzial an der Last in der Freilaufphase mit der Freilaufdiode und dem Shunt bestimmt.

Aus DE 198 51 732 A1 ist ein Verfahren und eine Vorrichtung zur Überwachung mindestens einer Stromregelstufe bekannt. Gemäß dem aus DE 198 51 732 A1 bekannten Verfahren erfolgt eine Überwachung wenigstens einer Stromregelstufe für einen elektrischen Verbraucher durch eine Vorrichtung, die wenigstens ein Schaltmittel und einen Stromregler umfasst. Der mindestens eine Verbraucher wird von einem durch ein Tastverhältnis bestimmten Strom durchflossen, wobei der Strom vom Stromregler auf einen Sollwert regelbar ist. Zur Überwachung wird das Tastverhältnis und/oder eine aus dem Tastverhältnis abgeleitete Größe mit einem Schwellwert verglichen und bei einer Abweichung von diesem Schwellwert auf das Vorliegen eines Fehlers erkannt. Anstelle des Tastverhältnisses kann ein Verhältnis zwischen dem Tastverhältnis und dem Sollwert gebildet werden und mit einem Vergleichswert verglichen werden. Ausgehend vom Tastverhältnis und der Spannung kann auch ein Stromwert bestimmt werden und mit einem Vergleichswert verglichen werden.

Die obenstehend skizzierten, aus dem Stand der Technik bekannten Diagnoseverfahren einer elektronischen Schaltendstufe sowie die aus DE 198 51 732 A1 bekannte Lösung sind mit dem Nachteil behaftet, dass während des pulsweitenmodulierten Betriebes von elektronischen Schaltendstufen hochohmige Kurzschlüsse nach Versorgungsspannung oder Masse nur eingeschränkt erkannt werden können.

Offenbarung der Erfindung

Der erfindungsgemäß vorgeschlagenen Lösung folgend wird ein Diagnoseverfahren vorgestellt, welches im Falle einer getaktet betriebenen elektronischen Endstufe mit induktiver Last hochohmige Nebenschlüsse z. B. parallel zum Schalter erkennen lassen. Dazu erfolgt ein Vergleich eines Stromwertes oder mehrerer Stromwerte in der Schaltphase mit dem Stromwert beziehungsweise den Stromwerten in der Freilaufphase, was die Erkennung eines Nebenschlusses ermöglicht. Dies gilt sowohl für die Erkennung eines Nebenschlusses nach Masse als auch für die Erkennung eines Nebenschlusses zur Versorgungsspannung $U_{bat}$.

Die Auswertung beruht darauf, dass sich der Strom durch die induktive Last zwischen Strom durch einen Nebenschlusswiderstand und Strom durch einen Messwiderstand $R_{mess}$ bei ein- und ausgeschalteter Endstufe unterschiedlich aufteilt. Bei durchgeschalteter Endstufe bilden der Nebenschlusswiderstand $R_{neben}$ und die Widerstände für die Strommessung $R_{mess}$ zusammen mit dem Durchschaltwiderstand $R_{DSon}$ der Endstufe eine Parallelschaltung. Im Verhältnis ist hierbei der zu erfassende Nebenschlusswiderstand viel größer als die Summe der anderen beiden Widerstände, so dass nahezu der gesamte Strom über den Messwiderstand $R_{mess}$ fließt.

Im ausgeschalteten Zustand der Endstufe teilt sich der Strom zwischen einem Freilaufkreis und dem Nebenschlusswiderstand auf. In diesem Falle ist der Strom durch den Nebenschlusswiderstand nicht viel kleiner und lässt sich während der Freilaufphase mit

$$I_{Nebenschluss} = \frac{Batteriespannung + Spannungsabfall\ Freilaufdiode}{Nebenschlusswiderstand}$$

$$I_{Freilaufdiode} \neq 0$$

$$I_{Nebenschluss} = \frac{Batteriespannung}{Nebenschlusswiderstand + ohmscher\ Anteil\ Last}$$

bei $I_{Freilaufdiode} = 0$ bestimmen.

Die Auswertung der unterschiedlichen Stromformen durch den Messwiderstand kann über folgende Ansätze durchgeführt werden. Bei einer Mittelwertbildung erfolgt ein Vergleich des Strommittelwertes bei durchgeschalteter Endstufe mit dem Strommittelwert bei ausgeschalteter Endstufe. Für die Mittelwertbildung können alle gängigen Methoden eingesetzt werden, so zum Beispiel analoge und digitale Integrationsverfahren. Ein Fehlstrom liegt dann vor, wenn die Mittelwerte abweichen. Danach kann mit einer Delta-Schwelle eine Fehlererkennung durchgeführt werden.

Alternativ zur Mittelwertbildung können einzelne Stromstützstellen ausgewertet werden. Abhängig von der geforderten Genauigkeit an die Auswertung ist der Abstand zwischen den Linien variierbar. Zu berücksichtigen ist aber, dass ein Erfassungszeitpunkt während der Einschaltphase und ein Erfassungszeitpunkt in der Ausschaltphase liegt. Ein Erfassungszeitpunkt kann auch eine Mittelung über Einzelwerte beinhalten.

Neben den dargestellten Auswerteverfahren Mittelwertbildung und Auswertung einzelner Stromstützstellen kann eine Auswertung über einen Sprung im Stromverlauf erfolgen. Ein Fehlstrom erzeugt eine sprunghafte Veränderung in der Kurvenform. Eine Auswertung kann über Verfahren mit ableitenden Eigenschaften oder bei digitalen Systemen über Steigungen zwischen erfassten Samplewerten erfolgen.

Zeichnung

Anhand der Zeichnung wird die Erfindung nachstehend eingehender beschrieben. Es zeigt:

Figur 1        eine Schaltungsübersicht mit eingezeichneten Strompfaden,

Figur 2        Platzierungsmöglichkeiten des Messwiderstands $R_{mess}$ in der Schaltung gemäß der Darstellung in Figur 1,

Figur 3.1      den Strompfad bei durchgeschalteter Endstufe mit $R_{Dson} < R_{Neb}$,

Figur 3.2      den Strompfad bei gesperrter Endstufe mit $R_{Dson} > R_{Neb}$,

Figur 4.1      die Stromform ohne Nebenschlusswiderstand.

Figur 4.2    die Stromform mit Nebenschlusswiderstand,

Figur 5    die Auswertung über den gemittelten Strom,

Figur 6    die Auswertung durch Bewertung einzelner Stromwerte und

Figur 7    die Auswertung über Detektion von Sprüngen im sich einstellenden Stromprofil.

Ausführungsvarianten

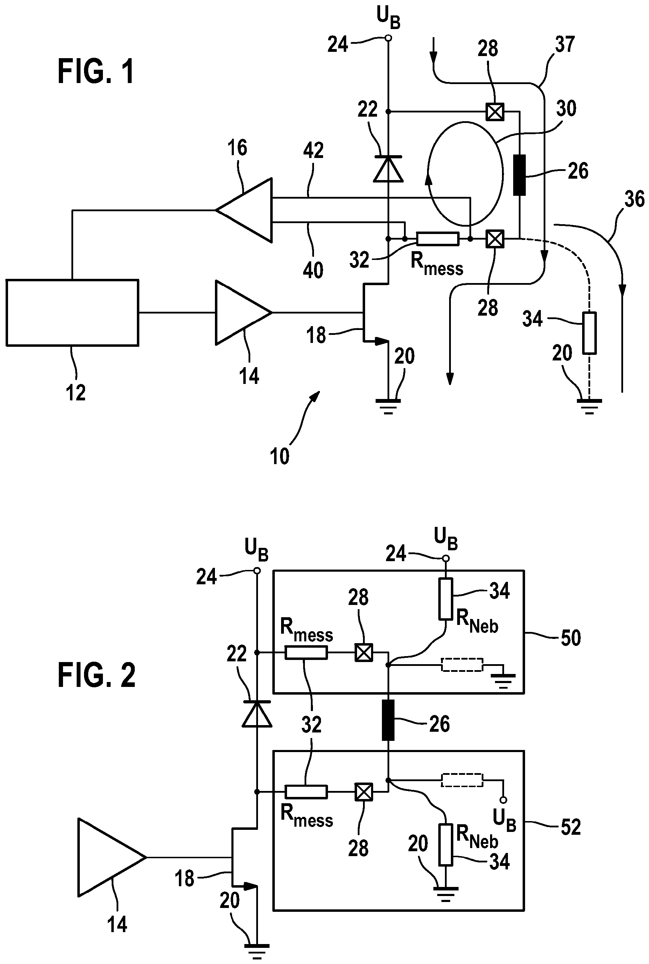

Der Darstellung gemäß Figur 1 ist in schematischer Darstellung eine Schaltungsübersicht mit eingezeichneten Strompfaden zu entnehmen.

Aus der Darstellung gemäß Figur 1 geht eine Diagnoseschaltung 10 hervor, die einen Regler 12 umfasst. Der Regler 12 kann entweder softwareimplementiert in einem Prozessor ausgebildet sein oder auch als Einzelbaustein ausgeführt werden. Dem Regler 12 ist ein Treiber 14 nachgeschaltet, der eine Endstufe 18 ansteuert. Der Regler 12 steht darüber hinaus mit einer Auswerteeinrichtung 16 in Verbindung, welcher ein erster Abgriff 40 und ein zweiter Abgriff 42 zugeführt werden, die vor beziehungsweise hinter einem Messwiderstand $R_{mess}$, Bezugzeichen 32, geschlossen sind. Die Endstufe hat eine Verbindung zur Masse 20. Daneben umfasst ein Freilaufkreis eine Freilaufdiode 22. Bei der Last 26 handelt es sich insbesondere um eine Last mit induktivem Anteil, so zum Beispiel eine Spule eines Druckreglers oder einer anderen Anbaukomponente. Die Last 26 ist an Klemmen 28 mit dem Freilaufkreis angeschlossen. Im Freilaufkreis läuft ein Freilaufstrom 30 für den Fall, dass die mindestens eine Endstufe 18 ausgeschaltet ist. Mit Bezugszeichen 34 ist ein Nebenschlusswiderstand $R_{Neb}$ gekennzeichnet, der durch den Nebenschlusswiderstand 34 fließende Strom $I_{Neb}$ ist mit Bezugszeichen 36 angedeutet. Der Laststrom ist durch Bezugszeichen 37 gekennzeichnet.

Weitere in der Diagnoseschaltung 10 durchführbare Diagnosen sind durch unabhängige Blöcke realisierbar und werden nachfolgend vernachlässigt. Für das erfindungsgemäß vorgeschlagene Prinzip der erweiterten Stromdiagnose ist die Realisierung des Reglers 12 von untergeordneter Bedeutung und kann - wie oben bereits erwähnt - sowohl als Softwareimplementierung in einem Prozessor oder als Einzelbaustein realisiert sein.

Der nachfolgend noch eingehender zu beschreibenden Figur 2 ist entnehmbar, dass der Messwiderstand $R_{mess}$ 32 sowohl vor als auch nach der Last 26 eingesetzt werden kann, bei der es sich insbesondere um eine Last mit induktivem Anteil handelt. Der Unterschied zwischen den beiden möglichen Platzierungen des Messwiderstandes $R_{mess}$ 32 besteht darin, ob ein nicht ausgeregelter Federstrom durch einen "weichen" Nebenschluss nach Batteriespannung $U_{bat}$ 24 oder zur Masse 20 erkannt werden soll. Die nachfolgenden Ausführungen im Zusammenhang mit den weiteren Figuren beziehen sich auf die Erkennung eines weichen Nebenschlusswiderstandes 34 nach Masse 20. Für einen Nebenschluss nach Batterie, d. h. zu $U_{bat}$, kann derselbe Ansatz eingesetzt werden. Mit dem vorgeschlagenen Verfahren lassen sich Kurzschlüsse sowohl nach Masse 20 als auch nach $U_{Bat}$ erkennen.

Der Darstellung gemäß Figur 2 ist entnehmbar, dass - wie im oberen Teil von Figur 2 dargestellt - der Messwiderstand $R_{mess}$ 32 in einer ersten Position 50 eingebaut werden kann. In diesem Falle befindet sich der Messwiderstand der Durchlaufseite der Freilaufdiode 22 nachgeschaltet. Dieser Fall wird nachfolgend nicht eingehender beschrieben.

Aus der Darstellung gemäß Figur 2 geht überdies hervor, dass der Messwiderstand $R_{mess}$, vergleiche Bezugszeichen 32, in einer zweiten Position 52 angeordnet werden kann, d. h. in Bezug auf die Freilaufdiode 22 zwischen dieser und der mindestens einen Endstufe 18 angeordnet werden kann. Für beide Platzierungsmöglichkeiten 50 beziehungsweise 52 des Messwiderstandes gilt, dass Ströme durch Nebenschlusswiderstände 34, die nicht innerhalb den jeweiligen rechteckigen Feldern liegen, auch durch den Messwiderstand $R_{mess}$, vergleiche Bezugszeichen 32, fließen und ausgeregelt werden. Diese Ströme führen nicht zu Stromerhöhungen durch die Last 26, bei der es sich insbesondere um eine induktive Last handelt. Die Darstellung gemäß Figur 2 stellt einen Ausschnitt der in Figur 1 dargestellten Diagnoseschaltung 10 dar, gibt jedoch nicht sämtliche Komponenten von dieser wieder.

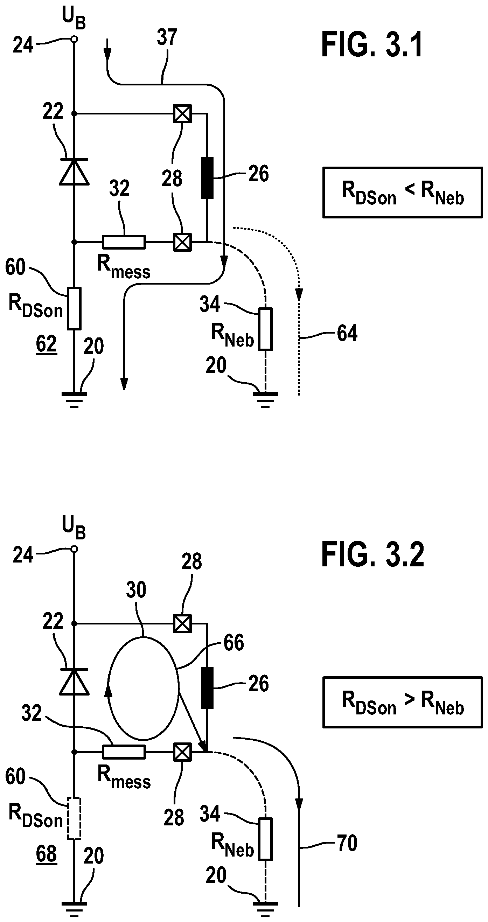

Den Darstellungen gemäß der Figuren 3.1 und 3.2 sind sich ergebende Strompfade bei durchgeschalteter und gesperrter Endstufe entnehmbar.

Für die Darstellung gemäß Figur 3.1 gilt, dass ein Durchschaltwiderstand $R_{DSon} < R_{Neb}$ ist.

In der Darstellung gemäß Figur 3.1 ist die mindestens eine Endstufe 18 durchgeschaltet, angedeutet durch Bezugszeichen 62. Der sich ergebende Durchschaltwiderstand ist durch Bezugszeichen 60 und mit $R_{Dson}$ bezeichnet. Bei dem durchgeschalteten Zustand 62 der mindestens einen Endstufe 18 bilden der Nebenschlusswiderstand $R_{Neb}$ und die Widerstände für die Strommessung $R_{mess}$ und der Durchschaltwiderstand $R_{DSon}$ der mindestens einen Endstufe 18 eine Parallelschaltung. Im Verhältnis ist in diesem Zustand der zu erfassende Nebenschlusswiderstand $R_{Neb}$ größer als die Summe der anderen beiden Widerstände, d. h. größer als die Summe aus $R_{mess}$ und $R_{DSon}$, so dass nahezu der gesamte Strom über den Messwiderstand $R_{mess}$, vergleiche Bezugszeichen 32, fließt. Bezugszeichen 37 bezeichnet den Laststrom.

Bei durchgeschalteter Endstufe 62 gemäß der Darstellung in Figur 3.1 ist somit der Stromfluss durch den Nebenschlusswiderstand von einer vernachlässigbaren Größenordnung. In der Darstellung gemäß Figur 3.1 befindet sich der Messwiderstand $R_{mess}$, vergleiche Bezugszeichen 32, in der in Figur 2 durch Bezugszeichen 52 angedeuteten zweiten Position.

Aus der Darstellung gemäß Figur 3.2 geht der Strompfad bei gesperrter Endstufe näher hervor. Für den in Figur 3.2 dargestellten Zustand gilt: $R_{DSon} > R_{Neb}$. Auch für diesen Betrachtungsfall, der sich auf die in Figur 2 mit Bezugszeichen 52 angedeutete zweite Position des Messwiderstandes $R_{mess}$, Bezugszeichen 32, bezieht, ist die mindestens eine Endstufe 18 gesperrt, angedeutet durch Bezugszeichen 68 und durch den in gestrichelten Linien dargestellten Durchschaltwiderstand $R_{DSon}$, Bezugszeichen 60. Für diesen Fall stellt sich ein Freilaufstrom 30 ein. Im ausgeschalteten Zustand 68 der mindestens einen Endstufe 16 teilt sich der Strom, wie in Figur 3.2 angedeutet, zwischen dem Freilaufkreis und dem Nebenschlusswiderstand 34 auf. In diesem Falle lässt sich der Strim $I_{Neb}$ während der Freilaufphase wie folgt bestimmen:

$$U_{Bat} = \frac{U_{Bat} + U_{FD}}{R_{Neb}}$$

Für den Fall, dass der Strom in der Freilaufdiode 22, $I_{Freilaufdiode} \neq 0$ ist, ergibt sich:  mit $U_{FD}$: Spannungsabfall über der Freilaufdiode.

Für den Fall, dass der Strom in der Freilaufdiode $I_{Freilaufdiode} = 0$ ist, ergibt sich der Nebenschlussstrom

$$I_{Nebenschluss} = \frac{U_{bat}}{R_{Neb} + ohmscher\ Anteil\ Last}.$$

Im in Figur 3.1 dargestellten Zustand 62, d. h. bei durchgeschalteter Endstufe 62, fließt nahezu der gesamte Strom über den Messwiderstand $R_{mess}$, wobei der Stromfluss durch den Nebenschlusswiderstand 34 nahezu vernachlässigbar ist, während in der Darstellung gemäß Figur 3.2, d. h. bei gesperrter mindestens einer Endstufe 18, vergleiche Bezugszeichen 68, der Stromfluss durch den Nebenschlusswiderstand 34 in der Größenordnung des Freilaufstromes 30 liegt, abhängig von der Größe des Nebenschlusswiderstandes. Der Stromfluss durch den Nebenschlusswiderstand 34 ist in der Darstellung gemäß Figur 3.2 durch Bezugszeichen 70 angedeutet, während in der Darstellung gemäß Figur 3.2, bei durchgeschalteter Endstufe 18, ein vernachlässigbarer Strom durch den Nebenschlusswiderstand 34 durch Bezugszeichen 64 angedeutet ist.

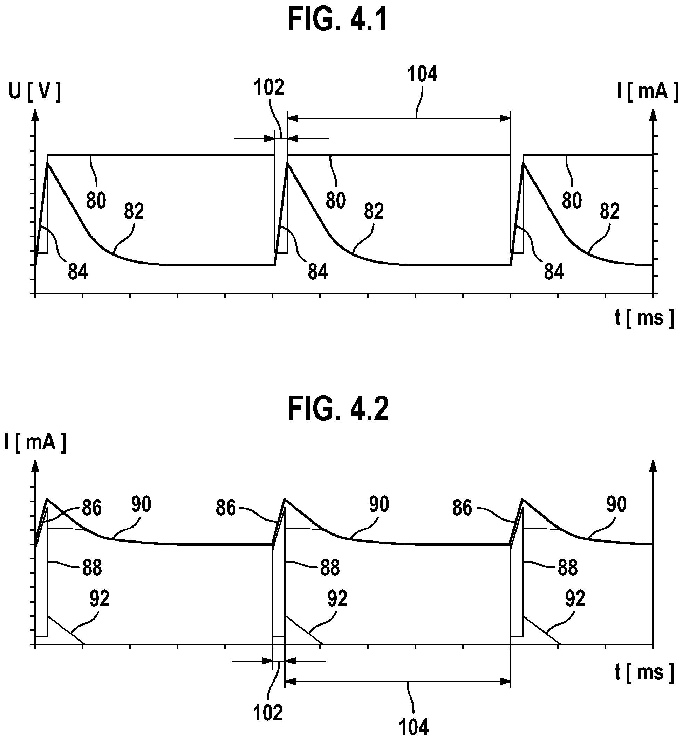

Den Figuren 4.1 und 4.2 lassen sich die sich einstellenden Spannungsverläufe über der Endstufe sowie die sich einstellenden Ströme durch die Last 26 entnehmen.

In der Darstellung gemäß Figur 4.1, die sich auf die Stromform ohne Nebenschlusswiderstand bezieht, ist der Spannungsverlauf über die mindestens eine Endstufe 18 durch Bezugszeichen 80 bezeichnet. Der sich korrespondierend zum in Figur 3.1 dargestellten Zustand über die Last 26 einstellende Strom ist durch Bezugszeichen 82 gekennzeichnet. Charakteristisch für den Strom durch die Last 82 ist dessen induktiver Anteil, repräsentiert durch eine erste Anstiegsflanke 84. Da gemäß des in Figur 3.1 dargestellten Strompfades bei durchgeschalteter mindestens einer Endstufe 18 der über den Nebenschlusswiderstand 34 fließende Strom vernachlässigbar ist, fehlt dieser in der Darstellung gemäß Figur 4.1. Die zum durchgeschalteten Zustand 62 der mindestens einen Endstufe 18 gehörende Figur 4.1 zeigt den Strom 82 durch die Last 26, welcher dem Strom durch den Messwiderstand $R_{mess}$, vergleiche Bezugszeichen 32 in Figur 3.1, entspricht.

Der Darstellung gemäß Figur 4.2, die sich auf die Stromform mit Nebenschlusswiderstand bezieht, ist demgegenüber zu entnehmen, dass bei gesperrter Endstufe 18, vergleiche Bezugszeichen 68 in Figur 3.2, der Spannungsverlauf 88 über der mindestens einen Endstufe 18 durch Bezugszeichen 88 angedeutet ist. Der sich einstellende Strom durch die Last 26 bei Vorliegen eines Nebenschlusswiderstandes ist durch die Kurve 90 angedeutet. Während gemäß der Darstellung in Figur 4.1 der Strom 82 durch die Last 26 dem durch den Messwiderstand $R_{mess}$ 32 fließenden Strom entspricht, ist der Strom, der gemäß der Darstellung in Figur 4.2 durch den Messwiderstand $R_{mess}$, Bezugszeichen 32, fließt, durch Bezugszeichen 92 angedeutet. Der in Figur 4.2 fließende Strom 90 durch die Last 26 ist gegenüber der Darstellung gemäß Figur 4.1 durch eine wesentlich kürzere, zweite Anstiegsflanke 86 gekennzeichnet. In der Darstellung gemäß Figur 4.2 entspricht der durch den Nebenschlusswiderstand 34 fließende Strom dem Spannungsverlauf über die Endstufe 88.

Aus einem Vergleich der Stromverläufe durch den Messwiderstand $R_{mess}$, Bezugszeichen 32 in Figuren 3.1 und 3.2, geht hervor, dass bei fehlendem Nebenschlusswiderstand nahezu der gesamte Strom über den Messwiderstand $R_{mess}$, Bezugszeichen 32, fließt, wobei dieser Strom in der Darstellung gemäß Figur 4.1 dem Kurvenverlauf 82 entspricht, während bei vorliegendem Nebenschlusswiderstand 34 der über diesen fließende Strom erheblich größer ist. Im Falle des in Figur 4.2 dargestellten Zustandes mit Nebenschlusswiderstand ist der über den Messwiderstand $R_{mess}$ 32 fließende Strom 92 erheblich kleiner.

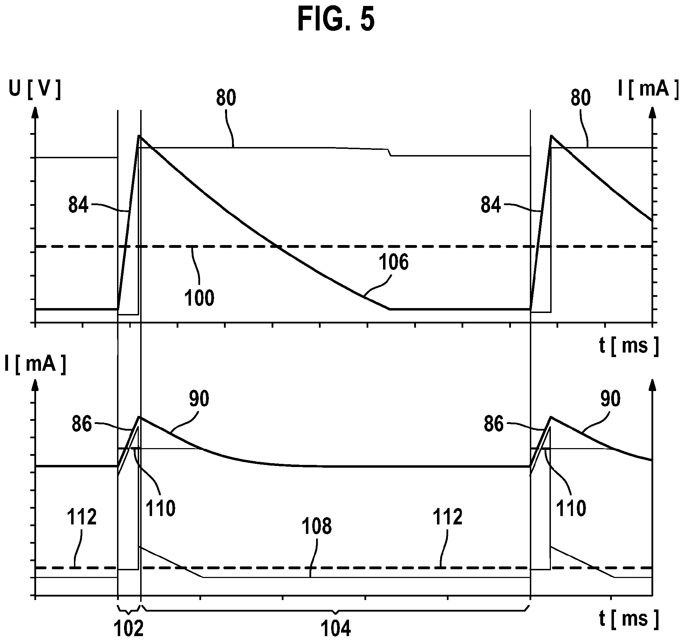

Den nachfolgenden Darstellungen gemäß der Figuren 5, 6 und 7 sind Auswerteverfahren der unterschiedlichen, in den Figuren 4.1 und 4.2 dargestellten Stromformen mit und ohne Nebenschlusswiderstand gegenübergestellt.

Aus der Darstellung gemäß Figur 5 geht hervor, dass die Ströme durch den Messwiderstand $R_{mess}$, vergleiche Bezugszeichen 32, ohne Nebenschlusswiderstand 34 dem Verlauf des Stromes 82 durch die Last 26 entsprechen, in Figur 5 durch Bezugszeichen 106 angedeutet, und bei vorliegendem Nebenschlusswiderstand dem Kurvenzug 108 entsprechen.

Im ersten Fall ist der sich einstellende Mittelwert des Stromes durch den Messwiderstand $R_{mess}$, vergleiche Bezugszeichen 32 in Figuren 3.1. und 3.2, durch Bezugszeichen 100 gekennzeichnet, im letzteren Falle ist der Mittelwert des durch den Messwiderstand $R_{mess}$ 32 fließenden Stromes bei eingeschalteter Endstufe 18 durch Bezugszeichen 110 und bei ausgeschalteter Endstufe durch Bezugszeichen 112 gegeben. In der Darstellung gemäß Figur 5 ist während einer Durchschaltzeit 102 die mindestens eine Endstufe 18 durchgeschaltet und während einer Sperrzeit 104 ausgeschaltet. In Bezug auf die Last 26 sind die sich während der Durchschaltzeit 102 der Endstufe 18 einstellenden Anstiegsflanken durch die Bezugszeichen 84 und 86 identifiziert, die den in Zusammenhang mit den Figuren 4.1 und 4.2 sich einstellenden Anstiegsflanken 84 beziehungsweise 86 entsprechen.

Die Mittelwertbildung erfolgt durch den Vergleich der Strommittelwerte 100, 110, 112 im durchgeschalteten Zustand 62 der mindestens einen Endstufe mit dem Strommittelwert der Endstufe im gesperrten Zustand 68. Die Mittelwertbildung gemäß der Darstellung in Figur 5 kann mittels aller gängigen Verfahren, so zum Beispiel durch analoge und digitale Integrationsverfahren, vorgenommen werden. Ein Fehlstrom liegt dann vor, wenn die Mittelwerte abweichen und durch eine Deltaschwelle eine Fehlererkennung durchgeführt werden kann.

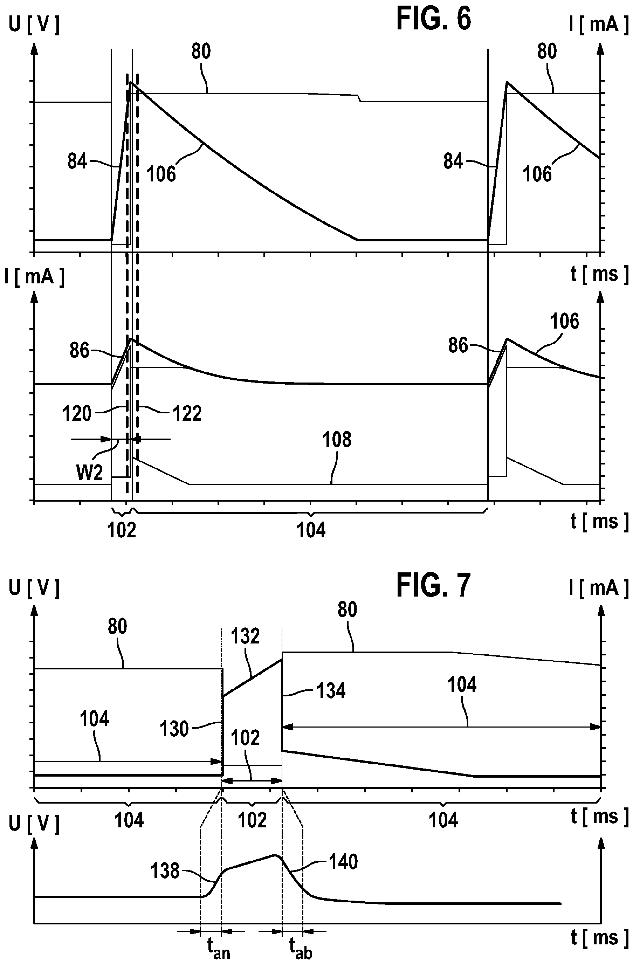

Figur 6 ist eine Auswertung einzelner Stromstützstellen der Ströme, die sich bei fehlendem und bei vorliegendem Nebenschlusswiderstand einstellen, zu entnehmen.

In Figur 6 ist analog zu Figur 5 durch Bezugszeichen 102 die Durchschaltzeit der mindestens einen Endstufe 18 dargestellt, während die mindestens eine Endstufe 18 in der Sperrzeit 104 ausgeschaltet ist. Aus der Darstellung gemäß Figur 6 geht hervor, dass ein erster Abtastzeitpunkt 120 vor dem Schalten der mindestens einen Endstufe 18 liegt, während ein zweiter Abtastzeitpunkt 122 nach dem Schaltvorgang der Endstufe 18 liegt. Analog zur Darstellung gemäß Figur 5 bezeichnen die Kurven 106 beziehungsweise 108 den sich jeweils einstellenden Stromfluss durch den Messwiderstand $R_{mess}$ (vergleiche Bezugszeichen 32 in den Figuren 3.1 und 3.2). Sinnvollerweise liegen die Abtastzeitpunkte 120 beziehungsweise 122 während der Einschaltphase der Endstufe 18 und während der Ausschaltphase derselben. Im Falle eines fehlenden Nebenschlusswiderstandes wird in Bezug auf den Messwiderstand der Verlauf des ersten Stromes 106 durch diesen zum ersten Abtastzeitpunkt 120 und zum zweiten Abtastzeitpunkt 122 erfasst, während bei einem vorliegenden Nebenschluss während der Abtastzeitpunkte 120 und 122 der sich einstellende zweite Stromfluss 108 durch den Messwiderstand $R_{mess}$ erfasst wird, der wesentlich niedriger ist als im ersten Falle, wo bei fehlendem Nebenschlusswiderstand der über den Messwiderstand $R_{mess}$ fließende Strom dem durch die bevorzugt insbesondere induktive Last 26 fließenden Strom entspricht. Das vorgeschlagene Verfahren lässt sich auch beim Übergang von der Sperrzeit 104 auf die Durchschaltzeit 102 der Endstufe 18 anwenden.

Der Darstellung gemäß Figur 7 ist eine Stromsprungauswertung zu entnehmen. Ohne Kenntnisse über den Schaltzustand wird gemäß dieser Auswertungsmethode mindestens ein Stromsprung 130 beziehungsweise 134 im Strom durch den Messwiderstand $R_{mess}$ erkannt, wobei zwischen dem ersten Stromsprung 130 und dem zweiten Stromsprung 134 ein flankenförmiger Stromanstieg 132 vorliegt. Während der Stromsprünge 130 beziehungsweise 134 stellt sich der Spannungsverlauf 80 über die Endstufe 18 ein. Die Stromsprünge 130, 134 treten zu Beginn der Durchschaltzeit 102 der Endstufe und nach deren Ende auf. Ist die Endstufe 18 hingegen gesperrt, vergleiche Bezugszeichen 62 in den Figuren 3.1 und 3.2, stellt sich kein Stromsprung ein.

Durch einen Fehlstrom, im vorliegenden Falle ein Strom über einen Nebenschlusswiderstand, wird eine sprunghafte Veränderung des Stromflusses erkannt. Eine Auswertung kann über Verfahren mit ableitenden Eigenschaften oder bei digitalen Systemen über Steigungen zwischen den jeweils aufgenommenen Sprungwerten erfolgen. Die Stromsprünge 130 beziehungsweise 134 treten beim Ein- beziehungsweise beim Ausschalten der Endstufe auf, mithin zu Beginn der Durchschaltzeit 102 und bei deren Ende. Bei einer Auaswertung mittels integrierender Verfahren können die Flanken der Stromsprünge 130, 134 verschliffen werden, so dass sich ergebende Gradienten aus dem Signal auszufiltern sind. Figur 7 zeigt die sich ergebenden Stromformen 138, 140 bei integrierenden beziehungsweise differenzierenden Verfahren. Eine Anstiegszeit $t_{an}$ und eine Abfallzeit $t_{ab}$ stellen eine Information über den sich einstellenden Nebenschlusswiderstand dar. Die gestrichelten Linien deuten die zeitliche Zuordnung zu den Stromsprüngen 130, 134 an.

## Patentansprüche

**1.** Verfahren zur Überwachung mindestens einer Endstufe (18) für eine induktive Last (26) mit einem Stromregler (12) einer Auswerteeinrichtung (16), **dadurch gekennzeichnet, dass** sich der Strom durch die induktive Last (26) zwischen einem Nebenschlusswiderstandsstrom und einem Strom durch einen Messwiderstand, der sowohl vor als auch nach der Last (26) eingesetzt werden kann, bei ein- und ausgeschalteter Endstufe unterschiedlich aufteilt und eine Erkennung eines Nebenschlusses zur Versorgungsspannung $U_{bat}$ oder eines Nebenschlusses nach Masse (20) durch Vergleich mindestens eines Stromwertes durch den Messwiderstand $R_{mess}$ in einer Schaltphase der mindestens einen Endstufe (18) mit mindestens einem Stromwert durch den Messwiderstand $R_{mess}$ in einer Freilaufphase der mindestens einen Endstufe (18) erfolgt.

2. Verfahren gemäß Anspruch 1, **dadurch gekennzeichnet, dass** bei einem durchgeschalteten Zustand (62) der Endstufe (18) ein Nebenschlusswiderstand $R_{Neb}$ (34), ein Durchschaltwiderstand $R_{DSon}$ (60) der mindestens einen Endstufe (18) und der Messwiderstand $R_{mess}$ (32) eine Parallelschaltung bilden.

3. Verfahren gemäß Anspruch 2, **dadurch gekennzeichnet, dass** der Nebenschlusswiderstand $R_{Neb}$ (34) wesentlich größer als die Summe aus Durchschaltwiderstand $R_{DSon}$ (60) und Messwiderstand $R_{mess}$ (32) ist und der gesamte Strom I über den Messwiderstand $R_{mess}$ (32) fließt.

4. Verfahren gemäß Anspruch 1, **dadurch gekennzeichnet, dass** sich in ausgeschaltetem (gesperrten) Zustand (68) der mindestens einen Endstufe (18) der Strom auf einen Freilaufstrom (30) und einen Nebenschlusswiderstandsstrom (70) aufteilt.

5. Verfahren gemäß Anspruch 4, **dadurch gekennzeichnet, dass** der durch den Nebenschlusswiderstand (34) fließende Nebenschlussstrom $I_{Neb}$ während einer Freilaufphase (30) entweder durch

$$I_{Neb} = \frac{U_{bat} + U_{FD}}{R_{Neb}}$$

mit $U_{FD}$ = Spannungsabfall Freilaufdiode (22)
und $I_{Freilaufdiode} \neq 0$ oder durch

$$I_{Neb} = \frac{U_{bat}}{R_{Neb} + R_{Last}}$$

mit: $R_{Last}$ : ohmscher Anteil Last (26)
und $I_{Freilaufdiode} = 0$
bestimmt wird.

6. Verfahren gemäß Anspruch 2, **dadurch gekennzeichnet, dass** der durch den Nebenschlusswiderstand $R_{Neb}$ fließende Strom $I_{Neb}$ entweder durch

$$I_{Neb} = \frac{U_{FD}}{R_{Neb}} \quad \text{oder} \quad I_{Neb} = \frac{U_{Bat} - U_{RDson}}{R_{Neb}}$$

bestimmt wird mit $U_{RDson} \triangleq$ Spannungsabfall über eingeschaltete Endstufe.

7. Verfahren gemäß einem oder mehrerer der vorhergehenden Ansprüche, **dadurch gekennzeichnet, dass** der am Messwiderstand $R_{mess}$ (32) resultierende Strom in der Auswerteeinrichtung (16) durch Mittelwertbildung (100, 110, 112), Auswertung einzelner Stützstellen (120, 122) oder über eine Detektion mindestens eines Stromsprungs (130. 134) erfolgt.

**Claims**

1. Method for monitoring at least one output stage (18) for an inductive load (26) using a current controller (12) of an evaluation device (16), **characterized in that** the current through the inductive load (26) is divided differently between a shunt resistor current and a current through a measuring resistor, which can be introduced both upstream and downstream of the load (26), when the output stage is switched on and switched off and a shunt with respect to the supply voltage $U_{bat}$ or a shunt to earth (20) is identified by comparing at least one current value through the measuring resistor $R_{meas}$ in a switching phase of the at least one output stage (18) with at least one current value through the measuring resistor $R_{meas}$ in a freewheeling phase of the at least one output stage (18) .

**2.** Method according to Claim 1, **characterized in that**, in an on state (62) of the output stage (18), a shunt resistor $R_{shunt}$ (34), an on-state resistor $R_{on}$ (60) of the at least one output stage (18) and the measuring resistor $R_{meas}$ (32) form a parallel circuit.

**3.** Method according to Claim 2, **characterized in that** the shunt resistance $R_{shunt}$ (34) is substantially greater than the sum of the on-state resistance $R_{on}$ (60) and the measuring resistance $R_{meas}$ (32) and all of the current I flows through the measuring resistor $R_{meas}$ (32).

**4.** Method according to Claim 1, **characterized in that**, in the off state (68) of the at least one output stage (18), the current is divided between a freewheeling current (30) and a shunt resistor current (70) .

**5.** Method according to Claim 4, **characterized in that** the shunt current $I_{shunt}$ flowing through the shunt resistor (34) during a freewheeling phase (30) is determined either by

$$I_{shunt} = \frac{U_{bat} + U_{FW}}{R_{shunt}}$$

where $U_{FW}$ = voltage drop freewheeling diode (22) and $I_{freewheelingdiode} \neq 0$
or by

$$I_{shunt} = \frac{U_{bat}}{R_{shunt} + R_{load}}$$

where: $R_{load}$: *ohmic component load* (26)
and $I_{freewheelingdiode} = 0$ .

**6.** Method according to Claim 2, **characterized in that** the current $I_{shunt}$ flowing through the shunt resistor $R_{shunt}$ is determined either by

$$I_{shunt} = \frac{U_{FW}}{R_{shunt}} \qquad \text{or} \qquad I_{shunt} = \frac{U_{bat} - U_{Ron}}{R_{shunt}}$$

where $U_{Ron} \triangleq$ voltage drop across switched-on output stage.

**7.** Method according to one or more of the preceding claims, **characterized in that** the current resulting at the measuring resistor $R_{meas}$ (32) is effected in the evaluation device (16) by forming the mean (100, 110, 112), evaluating individual grid points (120, 122) or by means of detecting at least one current jump (130, 134) .

**Revendications**

**1.** Procédé destiné à la surveillance d'au moins un étage de sortie (18) pour une charge inductive (26), avec un régulateur d'intensité de courant (12) d'un transducteur processeur (16), **caractérisé en ce que** le courant se divise de manière différente, selon que l'étage de sortie est activé ou désactivé, par la charge inductive (26) entre un courant de résistance de shunt et un courant par une résistance de mesure, lequel peut être utilisé aussi bien avant qu'après la charge inductive (26), et une reconnaissance d'un court-circuit destiné à la tension d'alimentation $U_{bat}$ ou d'un court-circuit vers la masse (20) a lieu par la comparaison d'au moins une valeur de courant à travers la résistance de mesure $R_{mess}$ dans une phase de commutation de l'au moins un étage de sortie (18), avec au moins une valeur de courant à travers la résistance de mesure $R_{mess}$ dans une phase de course libre de l'au moins un étage de sortie (18).

**2.** Procédé conformément à la revendication 1, **caractérisé en ce que**, dans le cas d'un état interconnecté (62) de l'étage de sortie (18), une résistance de shunt $R_{Neb}$ (34), une résistance d'interconnexion $R_{DSon}$ (60) de l'au moins un étage de sortie (18) et la résistance de mesure $R_{mess}$ (32) forment un montage en parallèle.

3. Procédé conformément à la revendication 2, **caractérisé en ce que** la résistance de shunt $R_{Neb}$ (34) est, pour l'essentiel, supérieure à la somme issue de la résistance d'interconnexion $R_{DSon}$ (60) et de la résistance de mesure $R_{mess}$ (32) et le courant total I circule à travers la résistance de mesure $R_{mess}$ (32).

4. Procédé conformément à la revendication 1, **caractérisé en ce que**, dans un état désactivé (c'est à dire bloqué) (68) de l'au moins un étage de sortie (18), le courant se divise en un courant de course libre (30) et un courant de résistance de shunt (70).

5. Procédé conformément à la revendication 4, **caractérisé en ce que** le courant de shunt $I_{Neb}$ qui circule à travers la résistance de shunt (34) pendant une phase de course libre (30) est déterminé soit par :

$$I_{Neb} = \frac{U_{bat} + U_{FD}}{R_{Neb}}$$

où $U_{FD}$ = chute de tension de la diode de course libre (22) ;
et où *Idiode de course libre* $\neq$ 0 ;
soit par :

$$I_{Neb} = \frac{U_{bat}}{R_{Neb} + R_{Last}} ,$$

où $R_{Charge}$ = proportion ohmique de la charge (26) ;
et où *Idiode de course libre* = 0 .

6. Procédé conformément à la revendication 2, **caractérisé en ce que** le courant $I_{Neb}$ qui circule à travers la résistance de shunt $R_{Neb}$ est déterminé soit par :

$$I_{Neb} = \frac{U_{FD}}{R_{Neb}} ,$$

soit par :

$$I_{Neb} = \frac{U_{Bat} - U_{RDson}}{R_{Neb}} ;$$

où $U_{RDson} \doteq$ chute de tension à travers l'étage de sortie activé.

7. Procédé conformément à l'une ou plusieurs des revendications précédentes, **caractérisé en ce que** le courant en résultant au niveau de la résistance de mesure $R_{mess}$ (32) a lieu dans le transducteur processeur (16) par le calcul de la valeur moyenne (100, 110, 112), par l'évaluation des divers points de référence (120, 122) individuels ou par une détection d'au moins une saute de courant (130, 134).

FIG. 1

FIG. 2

FIG. 3.1

$$R_{DSon} < R_{Neb}$$

FIG. 3.2

$$R_{DSon} > R_{Neb}$$

# FIG. 4.1

# FIG. 4.2

# FIG. 5

# FIG. 6

# FIG. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19851732 A1